(19) Europäisches Patentamt
European Patent Office
Office européen des brevets

(11) Veröffentlichungsnummer: **0 298 393**
**A2**

# (12) EUROPÄISCHE PATENTANMELDUNG

(21) Anmeldenummer: **88110552.2**

(51) Int. Cl.[4]: **G03F 7/08**

(22) Anmeldetag: **01.07.88**

(30) Priorität: **10.07.87 US 72188**

(43) Veröffentlichungstag der Anmeldung:
**11.01.89 Patentblatt 89/02**

(84) Benannte Vertragsstaaten:
**AT CH DE FR GB IT LI NL**

(71) Anmelder: **HOECHST CELANESE CORPORATION**
**Route 202-206 North**
**Somerville, N.J. 08876(US)**

(72) Erfinder: **Sangya, Jain**
**891 Ardsley Lane**
**Bridgewater New Jersey 08807(US)**

(74) Vertreter: **Euler, Kurt Emil, Dr. et al**
**HOECHST AG - Werk KALLE Patentabteilung**
**Postfach 3540 Rheingaustrasse 190**
**D-6200 Wiesbaden(DE)**

## (54) Verfahren zur Herstellung negativer Bilder aus einem positiv arbeitenden Photoresist mit einem Gehalt an Curcumin und lichtemfindlichen Gemisch enthaltend Curcumin.

(57) Die vorliegende Erfindung betrifft ein Verfahren zur Hersellung negativer Bilder aus einem positiv arbeitenden Photoresist. Man stellt ein lichtempfindliches Gemisch, bestehend im wesentlichen aus einem wasserunlöslichen, in alkalischen Lösungsmitteln löslichen Harz, 1,2-Chinon-2-diazid-4- und -5-sulfonsäureester, einen in Gegenwart von Säure wirkenden Vernetzer und den Farbstoff Curcumin in einem Lösungsmittel, her. Nach Aufbringen der Lösung auf einen Schichtträger und Verdunsten des Lösungsmittels wird bildmäßig belichtet, die lichtempfindliche Schicht getempert und die unbelichteten Bereiche durch Entwickeln entfernt.

Das erfindungsgemäße lichtempfindliche Gemisch zeigt eine hohe Auflösung des entwickelten Bildes sowie eine hohe Lichtempfindlichkeit.

EP 0 298 393 A2

Xerox Copy Centre

## Verfahren zur Herstellung negativer Bilder aus einem positiv arbeitenden Photoresist mit einem Gehalt an Curcumin und lichtempfindlichen Gemisch enthaltend Curcumin

Die vorliegende Erfindung betrifft ein Verfahren zur Herstellung negativer Bilder aus einem positiv arbeitenden Photoresist, beispielsweise aus einem strahlungsempfindlichen Photoresistgemisch, in dem wasserunlösliche, in wäßrigen Alkalien lösliche Harze als Bindemittel und Naphthochinondiazide als lichtempfindliche Verbindungen enthalten sind.

Die Herstellung positiv arbeitender Photoresists ist bekannt und beispielsweise in US-A 3,666,473, 4,115,128 und 4,173,470 beschrieben. Dazu gehören alkalilösliche Phenol-Formaldehyd-Novolakharze in Verbindung mit lichtempfindlichen Substanzen, in der Regel substituierten Naphthochinondiazidverbindungen. Die Harze und lichtempfindlichen Verbindungen werden in einem organischen Lösemittel oder Lösemittelgemisch gelöst und in dünner Schicht auf einen für den jeweiligen Zweck geeigneten Schichtträger aufgetragen.

Die Harzkomponente dieser Photoresistgemische ist in wäßrig-alkalischen Lösungen löslich, doch übt die lichtempfindliche Verbindung auf Naphthochinonbasis eine lösungshemmende Wirkung auf das Harz aus. Bei Belichtung ausgewählter Bereiche des beschichteten Trägers mittels aktinischer Strahlung erfährt die lichtempfindliche Ver bindung jedoch eine belichtungsbedingte strukturelle Umwandlung, und die Löslichkeit der belichteten Schichtbereiche wird größer als die der unbelichteten Bereiche.

Aufgrund dieses unterschiedlichen Lösungsverhaltens werden die belichteten Bereiche der Photoresistschicht beim Eintauchen des Schichtträgers in eine alkalische Entwicklerlösung abgelöst, während die nicht belichteten Bereiche im wesentlichen unverändert erhalten bleiben, so daß auf dem Schichtträger ein positives Reliefbild erhalten wird.

In den meisten Fällen wird der belichtete und entwickelte Schichtträger noch mit einer Ätzlösung behandelt. Die Photoresistschicht schützt die beschichteten Bereiche des Schichtträgers vor dem Ätzmittel, das folglich nur auf die schichtfreien Bereiche, d.h. im Fall eines positiv arbeitenden Photoresists, auf die mittels aktinischer Strahlung belichteten Bereiche, einwirken kann. Auf diese Weise wird auf dem Schichtträger ein Ätzbild erzeugt, das der Maske, Schablone oder sonstigen Vorlage entspricht, durch die vor dem Entwickeln belichtet wurde.

Das nach dem beschriebenen Verfahren auf dem Schichtträger erzeugte Photoresistreliefbild ist für verschiedene Anwendungszwecke geeignet, z. B. als Belichtungsmaske oder als Schablone für die Herstellung von Halbleiterbauelementen.

Zu den Kriterien, nach denen die Eignung eines Photore sistgemisches für kommerzielle Zwecke beurteilt wird, zählen die Lichtempfindlichkeit des Photoresists, der Kontrast nach der Entwicklung, die Resistauflösung und die Haftung der Resistschicht auf dem Schichtträger.

Die Resistauflösung betrifft das Vermögen eines Photoresistsystems, auch die feinsten Linien und Zwischenräume einer für die Belichtung verwendeten Maske wiederzugeben, wobei die belichteten und entwickelten Bereiche ein hohes Maß an Flankensteilheit aufweisen.

Auf vielen industriellen Einsatzgebieten, insbesondere bei der Herstellung von Halbleiterbauelementen, muß der eingesetzte Photoresist auch noch bei sehr geringen Strukturbreiten eine hohe Auflösung ergeben (1 µm und weniger). Diese Eigenschaft, d. h., die Fähigkeit zur Wiedergabe von Bildstellen sehr geringer Abmessungen, in einem Größenbereich von 1 µm oder weniger, ist für die großtechnische Herstellung integrierter Schaltungen auf Siliciumchips und ähnlichen Bauteilen von entscheidender Bedeutung.

Die Integrationsdichte auf einem solchen Chip kann beim Einsatz photolithographischer Verfahren nur durch eine Steigerung des Auflösungsvermögens des Photoresists ererhöht werden.

Photoresists werden allgemein in positiv und negativ arbeitende Photoresists eingeteilt. Ein negativ arbeitendes Photoresistgemisch zeichnet sich dadurch aus, daß die bei der bildmäßigen Belichtung vom Licht getroffenen Bereiche gehärtet werden. Sie bilden nach dem Entfernen der unbelichteten Bereiche mittels eines geeigneten Enwicklers die Bildstellen des Photoresists. Bei positiv arbeitenden Photoresists bilden dagegen die unbelichteten Bereiche die Bildstellen. Die vom Licht getroffenen Bereiche werden durch die Belichtung in wäßrig-alkalischen Entwicklern löslich. Während für die großtechnische Herstellung gedruckter Schaltungen überwiegend negativ arbeitende Photoresists verwendet werden, zeichnen sich positiv arbeitende Photoresists durch ein viel höheres Auflösungsvermögen aus und ermöglichen die Wiedergabe kleinerer Bildelemente. Daher werden zur Produktion von Schaltungen mit hoher Integrationsdichte in üblicher Weise positiv arbeitende Photoresists eingesetzt.

In der Praxis ist es für eine Reihe von Anwendungsgebieten vorteilhaft, einen positiv arbeitenden Photoresist auf Chinondiazidbasis mit hohem Auflösungsvermögen so umzuwandeln, daß er für eine negative Verarbeitung geeignet ist.

Das Interesse an einem Bildumkehrverfahren besteht aufgrund des Nutzens, den ein solches Verfahren für die Herstellungspraxis mit sich bringt. Die Vorteile der Bildumkehrung liegen u.a. darin, daß kein doppelter Satz komplementärer Masken für die positive und negative Bebilderung mehr benötigt wird, daß ein größerer Auflösungsbereich und Verarbeitungsspielraum als bei ausschließlich positiver Bebilderung vorhanden ist, und daß das Auftre ten stehender Wellen reduziert und größere Wärmebeständigkeit erreicht wird.

In diesem Zusammenhang wurden bereits zahlreiche Verfahren zur Bildumkehrung vorgeschlagen, wie z.B. S.A. MacDonald et al., "Image Reversal: The Production of a Negative Image in a Positive Photoresist", S. 114, IBM Research Disclosure, 1982; E. Alling et al., "Image Reversal of Positive Photoresist. A New Tool for Advancing Integrated Circuit Fabrication", Journal of the Society of Photo-Imaging Engineers, Band 539, S. 194, 1985; M.V. Buzuev et al., "Producing a Negative Image on a Positive Photoresist", SU No. 1,109,708; DE-PS 25 29 054 und US-PS 4,104,070.

Mit jedem dieser Verfahren sind jedoch auch Nachteile verbunden. Ein Hauptnachteil der gegenwärtig angewendeten Bildumkehrverfahren liegt darin, daß ein zusätzlicher Verfahrensschritt erforderlich ist, der entweder die Behandlung mit salzbildenden Verbindungen oder den Einsatz von besonders energiereichen Belichtungsquellen, wie z.B. Elektronenstrahlen, vorsieht.

In der EP-A-0 212 482 werden diese Nachteile durch Bereitstellen eines Verfahrens zur Herstellung negativer Bilder aus einem positiv arbeitenden Photoresist behoben, bei dem ein lichtempfindliches Gemisch verwendet wird, das bestimmte vernetzende Substanzen enthält. Eine Reihe von Eigenschaften waren aber nach wie vor verbesserungswürdig.

Es bestand daher die Aufgabe, ein Verfahren zur Herstellung von negativen Bildern aus einem positiv arbeitenden Photoresist bereitzustellen, bei dem der entstehende Photoresist eine höhere Auflösung, keine Linienverbreiterung durch Reflexion des Lichts aufweist und die thermische Stabilität des erhaltenen Bildes größer ist.

Gelöst wird die Aufgabe durch ein Verfahren zur Herstellung eines negativ arbeitenden lichtempfindlichen Gemisches, das die folgenden Verfahrensschritte umfaßt:

A) Herstellung eines lichtempfindlichen Gemisches, im wesentlichen bestehend aus

a) etwa 1 bis 25 Gewichtsprozent, bezogen auf die festen Bestandteile des Gemisches, einer lichtempfindlichen Verbindung der allgemeinen Formel I

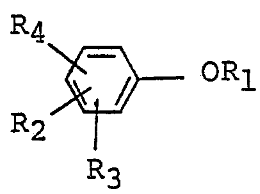

(I)

worin

$R_1$ 1,2-Benzochinon-2-diazid-4- oder -5-sulfonyl, 1,2-Naphthochinon-2-diazid-4- oder -5-sulfonyl- oder 1,2-Anthrachinon-2-diazid-4- oder -5-sulfonyl,

$R_2$, $R_3$, $R_4$ gleich oder verschieden sind und Wasserstoff, $R_5$, $-OR_6$, $-CO-R_5$ oder $-SO_2R_5$,

$R_5$ Alkyl, Aryl oder Aralkyl und $R_6$ Wasserstoff, Alkyl, Aryl, Aralkyl oder $R_1$ bedeuten,

und worin mindestens 70 % der vorhandenen Anzahl an Diazidgruppen 4-Sulfonyl-Isomeren sind,

b) etwa 75 bis 99 Gewichtsprozent, bezogen auf die festen Bestandteile des Gemisches, eines wasserunlöslichen, in wäßrig-alkalischen Medien löslichen Harzes als Bindemittel,

c) etwa 0,5 bis 20 Gewichtsprozent, bezogen auf die festen Bestandteile des Gemisches, aus einemVernetzer besteht, der in Gegenwart der bei Belichtung mit aktinischer Strahlung aus dem Diazidentstehenden Säure die Fähigkeit besitzt, das Harz nach b) zu vernetzen, und

d)einer ausreichenden Menge an Lösungsmittel, um die Bestandteile des Gemisches zu lösen,

B) Beschichten eines Schichtträgers mit dem licht-empfindlichen Gemisch,

C) Vortrocknen der Beschichtungslösung bei Temperaturen im Bereich von 20 bis 100 °C, bis das Lösungsmittel im wesentlichen verdunstet ist,

D) bildmäßiges Belichten der lichtempfindlichen Schicht mit aktinischer Strahlung,

E) Tempern der belichteten Schicht bei Temperaturen im Bereich von wenigstens 95 °C bis etwa 160 °C innerhalb von 10 Sekunden und mehr, in welcher Zeit die Vernetzung erfolgt und

F) Entfernen der unbelichteten Nichtbildstellen der Schicht mit einem geeigneten Entwickler, dadurch gekennzeichnet, daß das lichtempfindliche Gemisch gemäß Verfahrensstufe A als Komponente e) etwa 0,1 bis 10,0 Gew.-%, bezogen auf die festen Bestandteile des Gemisches, des Farbstoffs Curcumin enthält.

Die Verwendung von reflexmindernden Farbstoffen im allgemeinen ist auf dem Gebiet der Lithographie, insbesondere für stark reflektierende Schichtträger, wie z.B. Aluminium, ausführlich beschrieben.

Farbstoffe werden aber auch sowohl in einschichtigen als auch in mehrschichtigen Photoresistsystemen eingesetzt. In diesen Schichten sollten die Farbstoffe in erster Linie die folgenden Eigenschaften aufweisen: Sie sollten

a) in Photoresistlösungen gut löslich und stabil sein,

b) nach dem thermischen Konditionieren in dem Resistfilm verträglich sein,

c) einen wesentlichen Anteil des zur Belichtung des Resists verwendeten Lichts absorbieren,

d) einen Schmelzpunkt aufweisen, der höher sein soll als jede bei der Verarbeitung des Resists angewendete Temperatur, und

e) nicht sublimieren.

Der erfindungsgemäß verwendete Curcuminfarbstoff zeigt darüber hinaus noch die Vorteile hinsichtlich der lithographischen Eigenschaften des Resists, wie Entwicklungs kontrast, Auflösung und Lichtempfindlichkeit. Die Verwendung eines solchen geeigneten Farbstoffs wird dabei noch entscheidender, wenn mit monochromatischem Licht bildmäßig belichtet werden soll und der Schichtträger nicht vollständig eben ist. Lichtreflexionen vom Schichtträger können zu einer starken Ablenkung des Lichts und damit zur Belichtung des Photoresists auch außerhalb der transparenten Bereiche der Belichtungsmaske führen, so daß die Maske auf dem Photoresist nicht im Detail wiedergegeben werden kann. Der beschriebene Curcuminfarbstoff wird erfindungsgemäß in solchen Photoresistsystemen verwendet, bei denen es durch säurekatalysierte Vernetzung der belichteten Resistbereiche zu einer Bildumkehr kommt. Der Farbstoff darf hierbei, aufgrund seiner chemischen Struktur, die Vernetzung nicht behindern.

Dieser erfindungsgemäß verwendete Curcuminfarbstoff eignet sich insbesondere für die bildmäßige Belichtung bei Wellenlängen von 405 nm und 436 nm, er kann jedoch auch für Breitbandbelichtungen eingesetzt werden.

In der EP-A-0 200 129 sind Curcumin-Farbstoffe zwar schon für die Verwendung in positiv arbeitenden Photoresists beschrieben, die vorliegende Erfindung betrifft jedoch negativ arbeitende Systeme, die ein Vernetzungsmittel enthalten.

Die Stabilität und Verträglichkeit des Farbstoffs mit den übrigen Komponenten einer Photoresistlösung eines Photoresistfilms sind wesentliche Faktoren für die Auswahl der Farbstoffe. Im mikrolithographischen Bereich spielt das lithographische Verhalten des Resists eine wichtige Rolle, denn der Farbstoff übt entscheidenden Einfluß auf Kontrast und Auflösung des Resists aus. Das ist vor allem dann besonders wichtig, wenn die aufgelösten Strukturen bei der Mikrolithographie immer kleiner werden.

Das erfindungsgemäß verwendete Curcumin ist für den Einsatz in Novolak oder Polyvinylphenol und o-Chinondiazid enthaltenden Photoresists deshalb geeignet, da es in den für die Photoresists verwendeten Lösemitteln sehr gut löslich ist und die Ausbildung einwandfreier homogener Filme zuläßt. Da es keine basischen funktionellen Gruppen enthält, eignet es sich ganz besonders als Farbstoff für Photoresists, die für Bildumkehrverfahren eingesetzt werden können. Curcumin hat ein hohes Absorptionsvermögen für Wellenlängen zwischen 405 nm und 436 nm und absorbiert in geringerem Maße bei 365 nm. Aus diesem Grund wird Curcumin für Schmalbandbelichtungen bei 405 nm und 436 nm eingesetzt; es eignet sich aber auch für Breitbandbelichtungen.

Durch die erfindungsgemäße Verwendung von Curcumin in einem beschriebenen Verfahren wird das Verhältnis zwischen Belichtungsenergie und resultierender Linienbreite stark verbessert, der Verarbeitungsspielraum größer, die Auflösung des entwickelten Bildes höher, die Veränderung der Linienbreiten durch Reflexion des Lichtes weitestgehend ausgeschaltet, die Lichtempfindlichkeit höher, die thermische Stabilität des erhaltenen Bildes größer, und die Haftung zwischen dem Photoresist und den üblicher-weise verwendeten Schichtträgern verbessert.

Erfindungsgemäß wird ferner ein lichtempfindliches Gemisch vorgeschlagen, im wesentlichen bestehend aus

a) etwa 1 bis 25 Gewichtsprozent, bezogen auf die festen Bestandteile des Gemisches, einer lichtempfindlichen Verbindung der allgemeinen Formel I

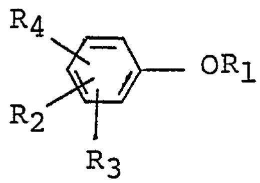

(I)

worin

$R_1$ 1,2-Benzochinon-2-diazid-4- oder 5-sulfonyl-, 1,2-Naphthochinon-2-diazid-4- oder 5-sulfonyl- oder 1,2-Anthrachinon-2-diazid-4- oder 5-sulfonyl-,

$R_2$, $R_3$, $R_4$ gleich oder verschieden sind und Wasserstoff, $R_5$, $-OR_6$, $-CO-R_5-$ oder $-SO_2R_5$,

$R_5$ Alkyl, Aryl oder Aralkyl und

$R_6$ Wasserstoff, Alkyl, Aryl, Aralkyl oder $R_1$ bedeuten,

und worin mindestens 70 % der vorhandenen Anzahlan Diazidgruppen 4-Sulfonyl-Isomeren sind,

b) etwa 75 bis 99 Gewichtsprozent, bezogen auf die festen Bestandteile des Gemisches, eines wasserunlöslichen, in wäßrig-alkalischen Medien löslichen Harzes als Bindemittel,

c) etwa 0,5 bis 20 Gewichtsprozent, bezogen auf die festen Bestandteile des Gemisches, eines Vernetzers, der in Gegenwart der bei Belichtung mit aktinischer Strahlung aus dem Diazid entstehenden Säure die Fähigkeit besitzt, das Harz nach b) zu vernetzen, und

d) einer ausreichenden Menge an Lösungsmittel, um die Bestandteile des Gemisches zu lösen.

Das lichtempfindliche Gemisch ist dadurch gekennzeichnet, daß es als Komponente e) etwa 0,1 bis 10,0 Gew.-%, bezogen auf die festen Bestandteile des Gemisches, des Farbstoffs Curcumin enthält.

Für die Herstellung der erfindungsgemäßen negativen Bildstrukturen wird zunächst eine Schicht aus dem vorstehend beschriebenen lichtempfindlichen Gemisch auf einen geeigneten Schichtträger aufgetragen und getrocknet. In dem lichtempfindlichen Gemisch sind ein Lösemittel, ein Vernetzungsmittel, ein Harz als Bindemittel und eine lichtempfindliche Verbindung mit o-Chinondiazidsulfonylgruppen sowie Curcumin enthalten.

Geeignete Bindemittel sind wasserunlösliche, in wäßrigen Alkalien lösliche Harze, wie z.B. Novolake, Polyvinylphenole, insbesondere Poly-p-vinylphenole.

Die Herstellung von Novolakharzen, die als Bindemittel für lichtempfindliche Gemische geeignet sind, ist bekannt. Sie wird beispielsweise von A. Knop und W. Scheib in "Chemistry and Application of Phenolic Resins", Kap. 4, Springer-Verlag, New York, 1979, beschrieben. Aus US-A 3,869,292 und 4,439,516 ist die Verwendung von Polyvinylphenolen bekannt. Auch die Verwendung von o-Chinondiaziden ist dem Fachmann bekannt und beispielsweise beschrieben in J. Kosar, "Light Sensitive Systems", Kap. 7.4., John Wiley & Sons, New York, 1965.

Diese lichtempfindlichen Verbindungen, die auch einen Bestandteil der erfindungsgemäßen Photoresist-Gemische bilden, werden vorzugsweise aus der Gruppe der lichtempfindlichen Verbindungen auf der Basis substituierter o-Chinondiazide ausgewählt, wie sie üblicherweise in den Rezepturen für positiv arbeitende Photoresistgemische verwendet werden. Geeignete Verbindungen dieser Art sind beispielsweise in den US-A 2,797,213, 3,106,465, 3,148,983, 3,130,047, 3,201,329, 3,785,825 und 3,802,885 beschrieben.

Als lichtempfindliche Verbindung werden bevorzugt 1,2-Chinondiazid-4-sulfonsäureester von Phenolderivaten eingesetzt. Offensichtlich ist im Rahmen der vorliegenden Erfindung nicht die Anzahl anellierter Ringe entscheidend, d.h., es können Benzochinone, Naphthochinone oder Anthrachinone verwendet werden. Auch die Art der phenolischen Komponente, mit der das Diazid verbunden ist, scheint nicht von Bedeutung zu sein. So kann es sich beispielsweise um ein 4-(2-Phenyl-prop-2-yl)phenolderivat gemäß US-A 3,640,992, oder um ein Mono-, Di- oder Trihydroxyphenylalkylketon oder ein Mono-, Di- oder Trihydroxybenzophenon gemäß US-A 4,499,171 handeln.

Als lichtempfindliche Verbindungen sind beispielsweise einsetzbar: 1,2-Naphthochinondiazid-4-sulfonylchlorid, das mit einer Phenolverbindung, wie z.B. einem Hydroxybenzophenon, wie Trihydroxybenzophenon und insbesondere 2,3,4-Trihydroxybenzophenon kondensiert wurde; 2,3,4-Trihydroxyphenylpentylketon-1,2-naphthochinon-2-diazid-4-sulfonsäuretrisester oder andere Alkylphenone; 2,3,4-Trihydroxy-3′-methoxybenzophenon-1,2-naphthochinon-2-diazid-4-sulfonsäuretrisester; 2,3,4-Trihydroxy-3′methylb enzophenon-1,2-naphthochinon-2-diazid-4-sulfonsäuretrisester und 2,3,4-Trihydroxybenzophenon-1,2-naphthochinon-2-diazid-4-sulfonsäuretrisester.

Um eine Bildumkehr zu erreichen, ist es im Rahmen dieser Erfindung wichtig, daß die in dem lichtempfindlichen Gemisch enthaltenen Diazidgruppen zumindest zum überwiegenden Teil, d.h. zu mindestens 70 %, vorzugsweise zu mindestens 80 % und insbesondere zu mindestens 90 %, aus 1,2-Naphthochinon-2-diazid-4-sulfonsäureestern bestehen. Zur Verbesserung der Resiststabilität können aber

auch 1.2-Naphthochinon-2-diazid-5-sulfonylgruppen oder durch organische Säuren substituierte Gruppen enthalten sein, gegebenenfalls in einem geringeren Anteil, insbesondere zu etwa 10 bis 20 %. Die 1,2-Naphthochinon-2-diazid-5-sulfonylgruppen können entweder getrennt als separate Verbindung oder als Teil einer Mischesterverbindung mit Hydroxybenzophenon, in der sowohl 4-Sulfonylgruppen als auch organische Säureestergruppen enthalten sind, auftreten. Geeignet sind z.B. die in US-Patentanmeldungen, Serial Nos. 858,616 und 859,284, vom 2. Mai 1986, beschriebenen Diazide.

Als Vernetzungsmittel dient eine Verbindung, die in Anwesenheit der bei der Belichtung des o-Chinondiazids mittels aktinischer Strahlung entstehenden Säuremenge zur Vernetzung des beschriebenen Novolak-, oder Polyvinylphenolharzes fähig ist. Zur Einleitung der Vernetzung ist eine Temperatur erforderlich, die ausreicht, um die Diffusion der Säure an das Vernetzungsmittel zu ermöglichen, die jedoch unterhalb der Zersetzungstemperatur des Diazids liegt. Allgemein handelt es ch dabei um Verbindungen, die unter den beschriebenen Säure- und Temperaturverhältnissen ein Carboniumion bilden können.

Als Vernetzungsmittel sind Verbindungen der allgemeinen Formel II geeignet

$(R_7O - CHR_8)_nA(CHR_9 - OR_{10})_m$ (II)

worin

A die Bedeutung B oder B-Y-B hat, wobei B ein gegebenenfalls substituierter, einkerniger oder anellierter mehrkerniger aromatischer Kohlenwasserstoff oder eine Sauerstoff oder Schwefel enthaltende heterocyclische Verbindung und Y eine Einfachbindung, $C_1$-$C_4$-Alkylen oder -Alkylendioxy, deren Ketten durch Sauerstoffatome unterbrochen sein können, -O-, -S-, $SO_2$-, -CO-, $CO_2$, -$OCO_2$, CONH oder Phenylendioxy ist,

$R_7$ und $R_8$ Wasserstoff, $C_1$-$C_6$-Alkyl, Cycloalkyl, gegebenenfalls substituiertes Aryl, Alkaryl oder Acyl,

$R_9$ und $R_{10}$ unabhängig voneinander Wasserstoff, $C_1$-$C_4$-Alkyl oder gegebenenfalls substituiertes Phenyl,

n eine Zahl von 1 bis 3 und

m eine Zahl von 0 bis 3, vorausgesetzt, daß n und m größer als 1 ist,

bedeuten.

In bevorzugter Ausführung entspricht das Vernetzungsmittel der allgemeinen Formel III

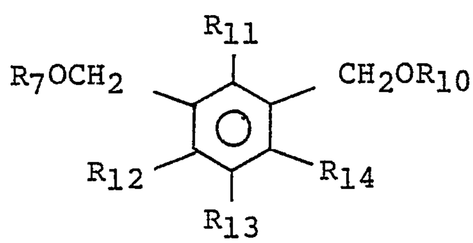

(III)

worin

$R_{11}$, $R_{12}$, unabhängig voneinander Wasserstoff,

$R_{13}$ und$R_{14}$ ($C_1$-$C_6$)-Alkyl, ($C_3$-$C_6$)-Cycloalkyl, Aryl, Arylalkyl oder $OR_7$ und

$R_7$ und $R_{10}$ unabhängig voneinander Wasserstoff, ($C_1$-$C_6$)-Alkyl, ($C_3$-$C_6$)-Cycloalkyl, Aryl oder Arylalkyl bedeuten.

Die bevorzugten Verbindungen sind, gemäß US-A-4,404,272, Dimethylolparakresol, und dessen Ether- und Esterderivate, 1-Methoxy-2,6-bis(hydroxymethyl)-4-methylbenzol, 2,6-Bis(hydroxymethyl)-4-methylphenol, 1-Methoxy-2,6-bis(methoxymethyl)-4-methylbenzol, 2,6-Bis(methoxymethyl)-4-methylphenol, 1-Methoxy-2,6-bis(methoxymethyl)-4-methylbenzol, 4,4′-Bis-methoxymethyl-diphenylether, Melaminformaldehyd-Harze und -Verbindungen und deren alkylierte Analoge mit 1 bis 3 Monomereinheiten, z.B. die unter den Handelsnamen ®Cymel (Hersteller American Cyanamid) und ®Resimene (Hersteller Monsanto Company) vertriebenen Produkte, z.B. Hexamethylolmelamin-hexamethylether.

Ferner können Epoxykresolnovolakharze verwendet werden, die der allgemeinen Formel IV entsprechen:

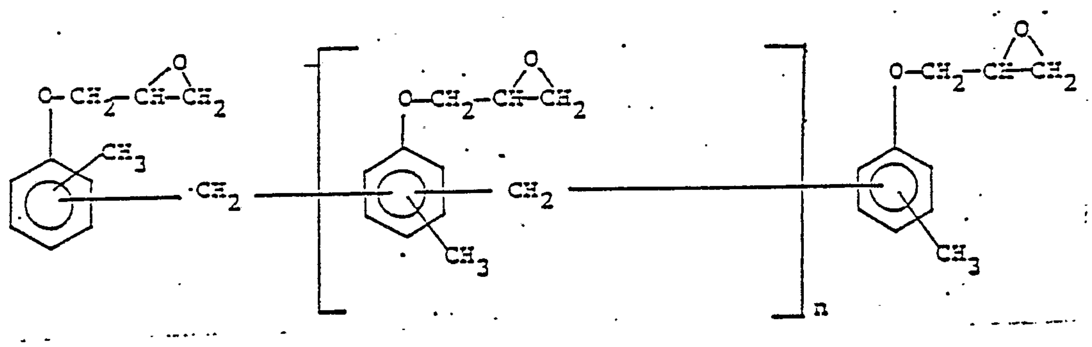

(IV)

n der n = 1 bis 10 bedeutet.

Das in den lichtempfindlichen Gemischen enthaltene Curcumin wird in Mengen von etwa 0,1 bis 10,0 Gewichtsprozent, vorzugsweise 0,1 bis 6,0 Gewichtsprozent, bezogen auf die festen Bestandteile des Gemisches, eingesetzt.

Zur Herstellung des erfindungsgemäßen lichtempfindlichen Gemischs werden die Bestandteile in einem geeigneten Lösemittelgemisch gelöst.

Der Anteil des harzartigen Bindemittels am fertigen Ge misch beträgt bevorzugt etwa 75 bis 99 Gewichtsprozent, insbesondere etwa 80 bis 90 Gewichtsprozent, und ganz besonders bevorzugt etwa 82 bis 85 Gewichtsprozent, jeweils bezogen auf den Gesamtfeststoffgehalt des Gemischs.

Der Anteil des o-Chinondiazides beträgt bevorzugt 1 bis 25 Gewichtsprozent, insbesondere etwa 1 bis 20 Gewichtsprozent, und ganz besonders bevorzugt etwa 10 bis 18 Gewichtsprozent, jeweils bezogen auf die festen Bestandteile des Gemisches.

Der Anteil des Vernetzungsmittels beträgt bevorzugt etwa 0,5 bis 20 Gewichtsprozent, insbesondere etwa 1 bis 10 Gewichtsprozent, und ganz besonders bevorzugt etwa 3 bis 6 Gewichtsprozent, bezogen auf die festen Bestandteile des Gemisches.

Das harzartige Bindemittel, das Vernetzungsmittel und das o-Chinondiazid werden mit geeigneten Lösemitteln bzw. Lösemittelgemischen, z.B. aus Propylenglykolalkyletheracetat, Butylacetat, Xylol, Ethylenglykolmonoethyletheracetat und vorzugsweise in Propylenglykolmethyletheracetat gelöst.

Der Lösung aus Bindemittel, lichtempfindlicher Verbindung, Vernetzungsmittel und Lösemittel kann noch Zusatzstoffe, wie Farbstoffe, Mittel zur Verhinderung von Streifenbildung, Verlaufmittel, Weichmacher, Haftvermittler, die Lichtempfindlichkeit erhöhende Stoffe, weitere Lösemittel und Netzmittel, z. B. nichtionische Netzmittel, beigemischt werden. Wichtig dabei ist, daß diese Zusatzstoffe nicht basisch sind.

Beispiele für Farbstoffe, die für die erfindungsgemäßen Photoresistgemische geeignet sind, sind Methylviolett 2B (C.I. 42 535), Kristallviolett (C.I. 42 555), Malachitgrün (C.I. 42 000), Viktoriablau B (C.I. 44 045) und Neutralrot (C.I. 50 040); sie können in einer Menge von l bis 10 Gewichtsprozent, bezogen auf die festen Bestandteile des Gemisches, zugesetzt werden. Die Farbstoffzusätze tragen zu einer besseren Bildauflösung bei, da durch sie eine Rückstreuung des Lichts vom Träger verhindert wird.

Mittel zur Verhinderung von Streifenbildung können in einer Menge bis zu 5 Gewichtsprozent, bezogen auf die festen Bestandteile des Gemisches, zugesetzt werden.

Geeignete Weichmacher sind beispielsweise Phosphorsäuretri-($\beta$-chlorethyl)ester, Stearinsäure, Dicampher, Polypropylen, Acetalharze, Phenoxyharze und Alkydharze. Sie werden in einer Menge von 1 bis 10 Gewichtsprozent, bezogen auf die festen Bestandteile des Gemisches, zugesetzt. Durch den Zusatz von Weichmachern werden die Beschichtungseigenschaften des Gemisches verbessert, so daß es möglich ist, eine glatte Schicht gleichmäßiger Dicke aufzutragen.

Zu den geeigneten Haftvermittlern zählen beispielsweise $\beta$-(3,4-Epoxycyclohexyl)-ethyltrimethoxysilan, p-Methyl disilan-methylmethacrylat, Vinyltrichlorsilan und $\gamma$-Aminopropyltriethoxysilan. Sie werden in einer Menge bis zu 4 Gewichtsprozent, bezogen auf die festen Bestandteile des Gemisches, zugesetzt.

Zur Erhöhung der Lichtempfindlichkeit können beispielsweise Pikrinsäure, Nicotinsäure oder Nitrozimtsäure in einer Menge von bis zu 20 Gewichtsprozent, bezogen auf die festen Bestandteile des Gemisches, zugesetzt werden. Durch diese Stoffe wird die Löslichkeit der lichtempfindlichen Schicht sowohl an den belichteten als auch an den unbelichteten Stellen erhöht. Diese Stoffe werden daher in solchen Fällen beigemischt, wo vor allem auf eine rasche Entwicklung Wert gelegt wird, auch wenn dies auf Kosten des Kontrastes geht. Die Einbuße an Kontrast rührt daher, daß nach dem Zusatz von die Lichtempfindlichkeit steigernden Mitteln der Entwickler nicht nur die belichteten Stellen der lichtempfindlichen Schicht schneller löst, sondern daß auch an den unbelichteten Stellen ein erhöhter Schichtverlust eintritt.

Der Lösemittelanteil des fertigen Gemisches beträgt bis zu 95 Gewichtsprozent, bezogen auf das

Gesamtfeststoffgewicht.

Zu den nichtionischen Netzmitteln, die eingesetzt werden können, zählen zum Beispiel Nonylphenoxypoly(ethylenoxy)ethanol, Octylphenoxy(ethylenoxy)ethanol und Dinonylphenoxypoly-(ethylenoxy)ethanol. Sie werden in einer Menge von bis zu I0 Gewichtsprozent, bezogen auf das Gesamtfest stoffgewicht, verwendet.

Die fertig zubereitete Photoresistlösung wird mit Hilfe gebräuchlicher Verfahren, wie Tauchen, Sprühen oder Schleudern, auf einen geeigneten Schichtträger aufgebracht. Wird beispielsweise im Schleuderverfahren beschichtet, wird der Feststoffgehalt der Photoresistlösung auf einen bestimmten Prozentsatz eingestellt, um in Abhängigkeit von der verwendeten Schleudervorrichtung und der Aufschleuderzeit die jeweils gewünschte Schichtdicke zu erzielen.

Als Materialien für den Schichtträger kommen zum Beispiel Silicium, Aluminium oder polymere Harze, Siliciumdioxid, dotiertes Siliciumdioxid, Siliciumnitrid, Polysilicium, Galliumarsenid, Tantal, Kupfer, Keramik und Aluminium-Kupfer-Mischungen in Frage.

Photoresistschichten der beschriebenen Art eignen sich besonders gut zum Aufbringen auf Siliciumwafer mit thermisch erzeugten Siliciumdioxidschichten, wie sie bei der Produktion von Mikroprozessoren und anderen Halbleiterbauelementen verwendet werden. Es kann auch ein Schichtträger aus Aluminum mit einer Aluminiumoxidschicht verwendet werden.

Außerdem sind zahlreiche polymere Harze, insbesondere transparente Polymere, wie zum Beispiel Polyester, als Schichtträger geeignet.

Nach dem Auftragen der Lösung auf den Schichtträger wird der Träger einer Vortrocknung bei etwa 20 °C bis 100 °C unterworfen. Diese Wärmebehandlung erfolgt, um die Restlösemittelkonzentration im Photoresist zu verringern und zu steuern, ohne daß es dabei zu einer merklichen thermischen Zersetzung der lichtempfindlichen Verbindung kommt. Es wird im allgemeinen angestrebt, den Gehalt an Lösemitteln auf ein Minimum zu senken, und diese erste Wärmebehandlung wird daher so lange fortgeführt, bis die Lösemittel praktisch vollständig verdampft sind und eine dünne Schicht aus Photoresistgemisch, deren Dicke etwa 1 µm beträgt, auf dem Schichtträger zurückbleibt. Bevorzugt liegt die Temperatur bei dieser Behandlung zwischen etwa 50 und 90 °C, insbesondere zwischen etwa 70 und 90 °C. Dieser Behandlungsschritt ist dann beendet, wenn sich der Lösemittelanteil nicht mehr nennenswert verringert. Die Wahl der jeweiligen Temperatur und Zeitdauer hängt von den vom Anwender gewünschten Resisteigenschaften, der verwendeten Ausrüstung und den für kommerzielle Zwecke erwünschten Beschichtungszeiten ab.

Bei einer Behandlung mit Hilfe von Heizplatten, sogenannten "Hot Plates", ist eine Dauer von bis zu 3 Minuten, bevorzugt bis zu 1 Minute, wirtschaftlich sinnvoll. Beispielsweise kann die Vortrocknung innerhalb von 30 Sekunden bei 90 °C durchgeführt werden. Der Schichtträger kann anschließend mit aktinischer Strahlung, insbesondere mit UV-Strahlung, durch geeignete Masken, Negative, Schablonen usw., bildmäßig belichtet werden. In bevorzugter Ausführung wird mit einer UV-Strahlungsquelle im Bereich von 405-436 nm belichtet.

An die Belichtung schließt sich das Tempern an, eine zweite Wärmebehandlung. Sie findet bei einer Temperatur im Bereich zwischen etwa 95 und 160 °C, bevorzugt zwischen 95 und 150 °C, insbesondere zwischen 110 und 140 °C, statt. Die Behandlung kann mit einem Heizplattensystem durchgeführt werden. Ihre Dauer liegt zwischen etwa 10 Sekunden und mehr, in welcher Zeit die Vernetzung des Harzes erfolgt. Vorzugsweise sind dies etwa 10 bis 90 Sekunden, insbesondere etwa 30 bis 90 Sekunden, sehr vorteilhaft kann auch eine Dauer von etwa 15 bis 45 Sekunden sein. Die Behandlung kann die angegebene Zeit auch überschreiten, doch führt dies im allgemeinen nicht zu einer weiteren Verbesserung des Ergebnisses. Die benötigte Zeit hängt jeweils von der Zusammensetzung des Photoresistgemischs und dem Schichtträger ab.

Temperatur und Dauer der Vortrocknung und des Temperns, d.h. der ersten und zweiten Wärmebehandlung, werden aufgrund der vom Anwender gewünschten Eigenschaften gewählt und auf den jeweils besten Wert eingestellt.

Falls erwünscht, kann man nach dem Tempern und Abkühlen des Materials die Schicht einer ganzflächigen Belichtung mit aktinischer Strahlung aussetzen. Die ganzflächige Belichtung wird vorzugsweise mit Strahlung im Wellenlängenbereich von etwa 200 bis 500 nm durchgeführt.

Als nächstes werden die mit dem Photoresistgemisch beschichteten und belichteten Schichtträger in eine geeignete Entwicklerlösung getaucht. Die Lösung wird vorzugsweise stark bewegt, was zum Beispiel durch Durchblasen von Stickstoff erfolgen kann. Die Schichtträger bleiben so lange in der Entwicklerlösung, bis die Photoresistschicht an den unbelichteten Stellen ganz oder doch fast ganz abgelöst ist. Als Entwickler werden vorzugsweise die bekannten wäßrig-alkalischen Entwicklerlösungen verwendet, wie zum Beispiel Natriumhydroxid- und Tetramethylammoniumhydroxidlösungen.

Im Anschluß an die Entwicklung kann noch eine weitere Wärmebehandlung der beschichteten Wafers durchgeführt werden, um die Haftung der Schicht und ihre chemische Resistenz gegen Ätzlösungen und andere Substanzen zu erhöhen. Die sich an die Entwicklung anschließende Wärmebehandlung ist beispielsweise eine Behandlung des Schichtträgers und der darauf aufgebrachten Schicht bei Temperaturen unterhalb des Erweichungspunktes der Beschichtung.

Für industrielle Anwendungen, insbesondere bei der Herstellung von Halbleiterbauelementen auf Siliciumträgern mit einer Siliciumdioxidschicht können die entwickelten Träger mit einer gepufferten Ätzlösung auf der Basis von Flußsäure behandelt werden. Die erfindungsgemäßen Photoresistgemische sind gegen derartige Ätzlösungen auf Säurebasis resistent und gewährleisten einen wirksamen Schutz der unbelichteten, mit dem Photoresistgemisch beschichteten Stellen des Trägers.

Anhand der folgenden Beispiele sollen die Vorteile des erfindungsgemäßen Verfahrens und der erfindungsgemäßen Gemische und deren Anwendung eingehend erläutert werden. Die Erfindung soll jedoch nicht auf diese Beispiele und die darin angegebenen Bedingungen, Parameter oder Werte beschränkt sein.

## Beispiel 1 (Vergleichsbeispiel)

Zu Vergleichszwecken wird die folgende Photoresistlösung hergestellt:

23,1 Gew.-% eines Kresol-Novolakharzes, mit einem Erweichungsbereich von 105 bis 120° C,

3,0 Gew.-% eines Kondensationsproduktes aus 2,3,4-Trihydroxybenzophenon mit einer 90:10-Mischung aus 1,2-Naphthochinon-2-diazid-4-sulfonylchlorid und 1,2-Naphthochinon-2-diazid-5-sulfonylchlorid und

1,0 Gew.-% Dimethylol-p-kresol in

72,9 Gew.-% Propylenglykolmonomethyletheracetat.

Der Kontrast und die Lichtempfindlichkeit dieses Gemisches werden im Bildumkehrverfahren wie folgt gemessen: Das lichtempfindliche Gemisch wird mit 4.000 U/min auf einen Silizium-Wafer aufgeschleudert und in einem Umluftofen 30 Minuten bei 90° C vorgetrocknet, um das Lösemittel zu entfernen. Anschließend wird der Wafer durch eine Maske mit bekannter, abgestufter optischer Dichte belichtet. Belichtet wird mit einer Quecksilberdampflampe bei einer Wellenlänge von 436 nm. Anschließend wird der Wafer 60 Sekunden bei 110° C auf einer Vakuum-Heizplatte getempert - und dann einer Breitband-Flutbelichtung mit 2.000 $mJ/cm^2$ unterzogen. Entwickelt wird in einer 0,2 n Tetramethylammoniumhydroxid-Lösung.

Die nach dem Entwickeln verbleibende Schichtdicke wird über den Logarithmus (lg) der Belichtungsenergie aufgetragen. Die Neigung dieser Kurve ergibt den Entwicklungskontrast des Resists und der Schnittpunkt der Kurve mit der Schichtdicke des Resists vor dem Entwickeln seiner Lichtempfindlichkeit. Für den Entwicklungskontrast erhält man einen Wert von 4,2 und für die Lichtempfindlichkeit 99 $mJ/cm^2$.

## Beispiel 2

Dem Resist aus Beispiel 1 werden 0,75 Gew.-% Curcumin zugesetzt und anschließend wie in Beispiel 1 verfahren.

Als Entwicklungskontrast erhält man einen Wert von 5,9 und als Lichtempfindlichkeit 112 $mJ/cm^2$.

## Beispiel 3

Dem Resist aus Beispiel 1 werden 0,9 Gew.-% Curcumin zugesetzt und anschließend wie in Beispiel 1 verfahren.

Als Entwicklungskontrast erhält man einen Wert von 5,7 und als Lichtempfindlichkeit 126 $mJ/cm^2$.

## Beispiel 4

Dem Resist aus Beispiel 1 werden 0,54 Gew.-% Curcumin zugesetzt und anschließend wie in Beispiel 1 verfahren.

Der Entwicklungskontrast und die Lichtempfindlichkeit werden im Bildumkehrverfahren wie folgt gemessen: Das lichtempfindliche Gemisch wird mit 4.000 U/min auf einen Silizium-Wafer aufgeschleudert und auf einer Vakuum-Heizplatte 60 Sekunden bei 100° C vorgetrocknet. Der Wafer wird durch eine Maske mit

bekannter, abgestufter optischer Dichte belichtet. Das Belichtungsgerät ist ein Perkin Elmer Microalign 220, mit dem eine Breitbandbelichtung durchgeführt wird. Anschließend wird der Wafer auf einer Vakuum-Heizplatte 60 Sekunden bei 130° C getempert und dann einer Breitband-Flutbelichtung mit 2.000 mJ/cm$^2$ unterzogen. Entwickelt wird in einer 0,22 n Tetramethylammoniumhydroxid-Lösung. Die nach dem Entwickeln verbleibende Schichtdicke wird über den Logarithmus (lg) der Belichtungsenergie aufgetragen. Die Neigung dieser Kurve ergibt den Entwicklungskontrast des Resists und der Schnittpunkt der Kurve mit der Schichtdicke des Resists vor dem Entwickeln ergibt die Lichtempfindlichkeit. Als Entwicklungskontrast erhält man einen Wert von 11 und als Lichtempfindlichkeit 11 mJ/cm$^2$.

Beispiel 5 (Vergleichsbeispiel)

Zum Vergleich wird ein lichtempfindliches Gemisch ohne Curcumin hergestellt.

Es wird ein lichtempfindliches Gemisch gemäß Beispiel 1 hergestellt und wie folgt verarbeitet: Der Entwicklungskontrast und die Lichtempfindlichkeit werden im Bildumkehrverfahren gemessen, wobei nach folgendem Verfahren gearbeitet wird: Das lichtempfindliche Gemisch wird mit 4.000 U/min auf einen Silizium-Wafer aufgeschleudert und auf einer Vakuum-Heizplatte 60 Sekunden bei 100° C vorgetrocknet. Der Wafer wird durch eine Maske mit bekannter, abgestufter optischer Dichte belichtet. Das Belichtungsgerät ist ein Perkin Elmer Microalign 220, mit dem eine Breitbandbelichtung durchgeführt wird. Anschließend wird der Wafer auf einer Vakuum-Heizplatte 60 Sekunden bei 127° C getempert und dann einer Breitband-Flutbelichtung mit 2.000 mJ/cm$^2$ unterzogen. Entwickelt wird in einer 0,22 n Tetramethylammoniumhydroxid-Lösung. Die nach dem Entwickeln verbleibende Schichtdicke wird über den Logarithmus (lg) der Belichtungsenergie aufgetragen. Die Neigung dieser Kurve ergibt den Entwicklungskontrast des Resists und der Schnittpunkt der Kurve mit der Schichtdicke des Resists vor dem Entwickeln ergibt die Lichtempfindlichkeit. Als Entwicklungskontrast erhält man einen Wert von 5,4 und als Lichtempfindlichkeit 15 mJ/cm$^2$.

Beispiel 6

Man verwendet ein lichtempfindliches Gemisch gemäß Beispiel 5, wobei jedoch 0,7 Gew.-% Curcumin zugegeben werden und arbeitet nach dem dort beschriebenen Verfahren. Als Entwicklungskontrast erhält man einen Wert von 9,4 und als Lichtempfindlichkeit 16 mJ/cm$^2$.

Beispiel 7

Man verwendet ein lichtempfindliches Gemisch gemäß Beispiel 5, wobei jedoch 1,5 Gew.-% Curcumin zugegeben werden. Als Entwicklungskontrast erhält man einen Wert von 34 und als Lichtempfindlichkeit 20 mJ/cm$^2$.

**Ansprüche**

1. Verfahren zur Herstellung negativer Bilder aus einem positiv arbeitenden Photoresist, gekennzeichnet durch die Kombination folgender Verfahrensschritte:

A) Herstellung eines lichtempfindlichen Gemisches, im wesentlichen bestehend aus

a) etwa 1 bis 25 Gewichtsprozent, bezogen auf die festen Bestandteile des Gemisches, einer lichtempfindlichen Verbindung der allgemeinen Formel I

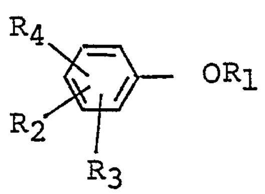

(I)

worin

$R_1$ 1,2-Benzochinon-2-diazid-4- oder -5-sulfonyl-, 1,2-Naphthochinon-2-diazid-4- oder -5-sulfonyl- oder 1,2-Anthrachinon-2-diazid-4- oder -5-sulfonyl,

$R_2$, $R_3$, $R_4$ gleich oder verschieden sind und Wasserstoff, $R_5$, $-OR_6$, $-CO-R_5$ oder $-SO_2R_5$,

$R_5$ Alkyl, Aryl oder Aralkyl und

$R_6$ Wasserstoff, Alkyl, Aryl, Aralkyl oder $R_1$ bedeuten.

b) etwa 75 bis 99 Gewichtsprozent, bezogen auf die festen Bestandteile des Gemisches, eines Novolaks oder Polyvinylphenol-, vorzugsweise Poly-p-vinylphenol-Harzes,

c) etwa 0,5 bis etwa 20 Gewichtsprozent, bezogen auf die festen Bestandteile des Gemisches, aus einem Vernetzer besteht, der in Gegenwart der bei Belichtung mit aktinischer Strahlung aus dem o-Chinondiazid entstehenden Säure die Fähigkeit besitzt, das Harz nach b) zu vernetzen und

d) einer ausreichenden Menge an Lösungsmittel, um die vorstehenden Verbindungen zu lösen,

B) Beschichten eines Schichtträgers mit dem lichtempfindlichen Gemisch nach A),

C) Vortrocknen der Lösung auf Temperaturen im Bereich von 20 bis 100 °C, bis das Lösungsmittel im wesentlichen verdunstet ist,

D) bildliches Belichten der lichtempfindlichen Schicht mit aktinischer Strahlung,

E) Tempern der belichteten Schicht auf Temperaturen im Bereich von wenigstens 95 °C bis etwa 160 °C innerhalb von 10 Sekunden und mehr, in welcher Zeit die Vernetzung erfolgt und

F) Entfernen der unbelichteten Bereiche der Schicht miteinem alkalischen Entwickler, dadurch gekennzeichnet, daß das lichtempfindliche Gemisch gemäß Verfahrensstufe A als Komponente c) etwa 0,1 bis 10,0 Gew.-%, bezogen auf die festen Bestandteile des Gemisches, des Farbstoffs Curcumin enthält.

2. Verfahren nach Anspruch 1, dadurch gekennzeichnet, daß man als lichtempfindliche Verbindung einen Mischester aus 2,3,4-Trihydroxybenzophenon und 1,2-Naphthochinon2-diazid-4- und -5-sulfonsäure verwendet.

3. Verfahren nach Anspruch 1, dadurch gekennzeichnet, daß man als Vernetzer eine Verbindung der allgemeinen Formel II

$(R_7O-CHR_8)_nA(CHR_9-OR_{10})_m$ (II)

verwendet,

in der AB oder B-Y-B ist, wobei B einen gegebenenfalls substituierten einkernigen oder anellierten mehrkernigen aromatischen Kohlenwasserstoff oder eine Sauerstoff oder Schwefel enthaltende heterocyclische aromatische Verbindung darstellt und Y eine Einfachbindung, $C_1$ bis $C_4$-Alkylen oder Alkylendioxy, deren Ketten durch Sauerstoffatome unterbochen sein können, -O-, -S-, $-SO_2-$, -CO-, $-CO_2-$, $-O-CO_2-$, -CONH-oder Phenylendioxy bedeutet,

$R_7$ und $R_8$ Wasserstoff, $C_1$ bis $C_6$-Alkyl, Cycloalkyl-, gegebenenfalls substituiertes Aryl, Aralkyl oder Acyl ist,

$R_9$ und $R_{10}$ unabhängig voneinander Wasserstoff, $C_1$ bis $C_4$-Alkyl oder gegebenenfalls substituiertes Phenyl,

n eine Zahl von 1 bis 3 und

m eine Zahl von 0 bis 3, vorausgesetzt, daß n + m größer als 1 ist,

bedeuten.

4. Verfahren nach einem oder mehreren der Ansprüche 1 bis 3, dadurch gekennzeichnet, daß man als Vernetzer eine Verbindung der allgemeinen Formel III

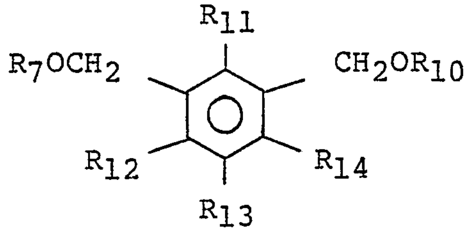

(III)

verwendet, worin

$R_{11}$, $R_{12}$, unabhängig voneinander Wasserstoff, $R_{13}$ und $R_{14}$ $(C_1-C_6)$-Alkyl, $(C_3-C_6)$-Cycloalkyl, Aryl, Aryl-alkyl oder $OR_7$ und

$R_7$ und $R_{10}$ unabhängig voneinander Wasserstoff, $(C_1-C_6)$-Alkyl, $(C_3-C_6)$-Cycloalkyl, Aryl oder Arylalkyl bedeuten.

5. Verfahren nach einem oder mehreren der Ansprüche 1 bis 4, dadurch gekennzeichnet, daß man als Lösungsmittel Propylenglykolmonoalkyletheracetat verwendet.

6. Verfahren nach einem oder mehreren der Ansprüche 1 bis 5, dadurch gekennzeichnet, daß man das Tempern bei Temperaturen im Bereich von etwa 95 bis etwa 150 °C durchführt.

7. Verfahren nach den Ansprüchen 1 und 6, dadurch gekennzeichnet, daß man das Tempern innerhalb von etwa 10 bis etwa 90 Sekunden durchführt.

8. Verfahren nach Anspruch 1, dadurch gekennzeichnet, daß man einen wäßrig-alkalischen Entwickler verwendet.

9. Verfahren nach den Ansprüchen 1 und 8, dadurch gekennzeichnet, daß man als Entwickler eine wäßrige Lösung von Natriumhydroxid und/oder Tetramethylammoniumhydroxid verwendet.

10. Verfahren nach Anspruch 1, dadurch gekennzeichnet, daß man einen Novolak und 2,6-Dimethylol-4-kresol als Vernetzer verwendet, und das Tempern bei einer Temperatur im Bereich von 110 bis 140 °C innerhalb von 90 Sekunden durchführt und für die Entwicklung eine wäßrige Lösung von Natriumhydroxid und/oder Tetramethylammoniumhydroxid einsetzt.

11. Lichtempfindliches Gemisch, im wesentlichen bestehend aus

a) etwa 1 bis 25 Gewichtsprozent, bezogen auf die festen Bestandteile des Gemisches, einer lichtempfindlichen Verbindung der allgemeinen Formel I

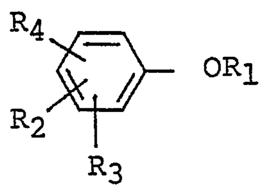

(I)

worin

$R_1$ 1,2-Benzochinon-2-diazid-4- oder 5-sulfonyl-, 1,2-Naphthochinon-2-diazid-4- oder 5-sulfonyl- oder 1,2-Anthrachinon-2-diazid-4- oder -5-sulfonyl,

$R_2$, $R_3$, $R_4$ gleich oder verschieden sind und Wasserstoff, $-R_5$, $-OR_6$, $-CO-R_5$ oder $-SO_2R_5$,

$R_5$ Alkyl, Aryl oder Aralkyl und

$R_6$ Wasserstoff, Alkyl, Aryl, Aralkyl oder $R_1$ bedeuten,

und worin mindestens 70 % der vorhandenen Anzahl an Diazidgruppen 4-Sulfonyl-Isomeren sind,

b) etwa 75 bis 99 Gewichtsprozent, bezogen auf die festen Bestandteile des Gemisches, eines wasserunlöslichen, in wäßrig-alkalischen Medien löslichen Harzes als Bindemittel,

c) etwa 0,5 bis 20 Gewichtsprozent, bezogen auf die festen Bestandteile des Gemisches, aus einem Vernetzer besteht, der in Gegenwart der bei Belichtung mit aktinischer Strahlung aus dem Diazid entstehenden Säure die Fähigkeit besitzt, das Harz nach b) zu vernetzen, und

d) einer ausreichenden Menge an Lösungsmittel, um die Bestandteile des Gemisches zu lösen, dadurch gekennzeichnet, daß das lichtempfindliche Gemisch als Komponente e) etwa 0,1 bis 10,0 Gew.-%, bezogen auf die festen Bestandteile des Gemisches, den Farbstoff Curcumin enthält.